# EUROPÄISCHE PATENTANMELDUNG

(11) **EP 1 051 063 A1**
(43) Veröffentlichungstag der Anmeldung: **08.11.2000**
(21) Anmeldenummer: 99810403.8
(22) Anmeldetag: 07.05.1999
(51) Int. Cl.: H05K 13/02

(54) **Teilezuführungsvorrichtung**

(71) Anmelder: Mikron SA Boudry, 2017 Boudry (CH)
(72) Erfinder: Gertsch, Christoph, 3613 Steffisburg (CH); Ryser, Olivier, 2028 Vaumarcus (CH)
(74) Vertreter: Roshardt, Werner Alfred, Dipl.-Phys.

(57) **Zusammenfassung**

Eine Teilezuführungsvorrichtung für einen Roboter weist eine für den Roboter zugängliche Selektionszone (40), eine Einrichtung (40) zum stochastischen Verändern der Ausrichtung und/oder der Lage der Teile und eine Einrichtung mit einem Teilerezirkulationselement (30) zum Rezirkulieren der Teile auf. Die Einrichtung (40) zum stochastischen Verändern der Ausrichtung,und/oder der Lage der Teile ist eine gleichzeitig als Selektionszone (40) ausgebildete Rüttelplattform (40). Das Teilerezirkulationselement (30) und die Rüttelplattform (40) sind relativ zueinander derart in zwei verschiedene Positionen bringbar, dass in der ersten Position die Rüttelplattform (40) mit Teilen vom Teilerezirkulationselement (30) beschickt werden kann und in der zweiten Position die Teile, die von der Rüttelplattform (40) herunter fallen, vom Teilerezirkulationselement (30) aufgefangen werden können. Durch die Ausbildung des Teilerezirkulationselementes (30) einerseits als Teilereservoir zum Beschicken der Rüttelplattform (40) mit Teilen vom Teilerezirkulationselement (30) und andrerseits als Auffangelement (30) für von der Rüttelplattform (40) herunter fallende Teile kann die Teilezuführungsvorrichtung ohne Teiletransportvorrichtung für eine horizontale Förderung der Teile, wie Förderbänder, Linearschienen o.ä., auskommen. Dies erlaubt eine äusserst einfache und raumsparende Konstruktion der Teilezuführungsvorrichtung.

## Beschreibung

### Technisches Gebiet

Die Erfindung betrifft eine Teilezuführungsvorrichtung nach dem Oberbegriff des Anspruchs 1.

### Stand der Technik

Für die Übergabe von Teilen, die in Form von Schüttgut in einem Speicherbehälter angeliefert werden, an einen Roboter, müssen die Teile in der Regel zunächst voneinander getrennt (d.h. vereinzelt) und in eine für die Übergabe an den Roboter geeignete Ausrichtung und Lage gebracht werden. Diese Aufgabe wird von sogenannten Teilezuführungsvorrichtungen (auch Zuführsysteme oder englisch "parts feeder" genannt) ausgeführt. Eine Teilezuführungsvorrichtung nimmt demgemäss Teile in Form von Schüttgut auf, vereinzelt die Teile und übergibt sie in einer geeigneten Ausrichtung und Lage an einen Roboter. Der Roboter ergreift die geeignet ausgerichteten Teile in einer Selektionszone der Teilezuführungsvorrichtung und übergibt sie anschliessend zur weiteren Bearbeitung und/oder zur Montage an ein Montagesystem, eine Bearbeitungsstation o.ä. Unter einem Roboter ist in diesem Zusammenhang irgend ein Apparat zu verstehen, der ausgebildet ist, um Teile in einer günstigen Ausrichtung und Lage zu ergreifen und sie anschliessend vom Ort des Ergreifens bzw. der Selektion weg zu fördern.

Die meisten gebräuchlichen Teilezuführungsvorrichtungen umfassen für die Vereinzelung der Teile und die Ausrichtung bzw. Positionierung derselben ein mechanisches Filter in Form eines um eine vertikale Achse drehbaren, vibrierenden Topfes. Der Topf ist mit innenliegenden, spiralförmigen Schneckenzügen versehen. Entlang der Schnekkenzüge sind eine Vielzahl von mechanischen Führungselementen und Schranken angeordnet. Aufgrund der vibrierenden Drehbewegung des Topfes werden die Teile den Schneckenzügen entlang nach oben, zum Topfausgang hin transportiert. Durch die Schranken und Führungselemente werden nur Teile in einer bestimmten Ausrichtung bis zum Topfausgang transportiert, die restlichen fallen auf den Boden des Topfes zurück, um einen erneuten Transportvorgang den Schneckenzügen entlang zu beginnen. Vom Topfausgang aus werden die Teile typischerweise über Linearschienen weiter gefördert, um ihre Vereinzelung und Ausrichtung beizubehalten.

Die mechanischen Filter in Form von vibrierenden Töpfen weisen den Nachteil auf, dass sie spezifisch auf bestimmte Teile zugeschnitten sind. Sie sind äusserst unflexibel in Bezug auf Änderungen der Teile. Bei einer Modifikation der geometrischen Form der Teile muss meistens der ganze vibrierende Topf neu entworfen, konstruiert und ausgetestet werden. Zudem sind sowohl die Schneckenzüge von vibrierenden Töpfen als auch die an die Töpfe anschliessenden Linearschienen anfällig auf Blockierungen durch defekte und/oder besonders ungünstig positionierte Teile, insbesondere dann, wenn diese eine komplizierte geometrische Form aufweisen.

In der US-amerikanischen Patentschrift US-A-5 687 831 (Adept Technology) wird eine Teilezuführungsvorrichtung beschrieben, die eine im Vergleich zu vibrierenden Töpfen verbesserte Flexibilität in Bezug auf unterschiedliche Teileformen aufweist. Die Teilezuführungsvorrichtung gemäss US-A-5 687 831 umfasst eine im wesentlichen horizontale Transportstrecke, auf welcher die Teile zu einer Auswahlzone transportiert werden. In der Auswahlzone werden günstig ausgerichtete und angeordnete Teile mittels einer Videokamera erkannt und anschliessend durch einen Roboter ergriffen und an ein Montagesystem übergeben. Die nicht ausgewählten Teile werden mittels eines Rezirkulationssystems für einen erneuten Durchgang durch die Teilezuführungsvorrichtung hindurch an den Anfang der Transportstrecke zurück geführt. Während der Rückführung wird die Ausrichtung und die Lage der Teile verändert, damit sie beim nächsten Durchgang möglicherweise günstig ausgerichtet sind und in der Auswahlzone ausgewählt werden.

Die Teilezuführungsvorrichtung gemäss US-A-5 687 831 ist zwar einigermassen flexibel in Bezug auf unterschiedliche Teileformen. Sie ist jedoch konstruktiv relativ aufwendig und erfordert einen beträchtlichen Bauraum für die Anordnung der Transportstrecke, der Auswahlzone und des Rezirkulationssystems.

### Darstellung der Erfindung

Aufgabe der vorliegenden Erfindung ist die Schaffung einer Teilezuführungsvorrichtung, die konstruktiv einfach, raumsparend und flexibel in Bezug auf unterschiedliche Teileformen ist.

Die Lösung der Aufgabe ist durch die Merkmale der unabhängigen Patentansprüche definiert.

Gemäss der Erfindung weist eine Teilezuführungsvorrichtung für einen Roboter eine für den Roboter zugängliche Selektionszone, eine Einrichtung zum stochastischen Verändern der Ausrichtung und/oder der Lage der Teile und eine Einrichtung mit einem Teilerezirkulationselement zum Rezirkulieren der Teile auf. Die Einrichtung zum stochastischen Verändern der Ausrichtung und/oder der Lage der Teile ist eine gleichzeitig als Selektionszone ausgebildete Rüttelplattform. Das Teilerezirkulationselement und die Rüttelplattform sind relativ zueinander derart in zwei verschiedene Positionen bringbar, dass in der ersten Position die Rüttelplattform mit Teilen vom Teilerezirkulationselement beschickt werden kann und in der zweiten Position die Teile, die von der Rüttelplattform herunter fallen, vom Teilerezirkulationselement aufgefangen werden können.

Im Zuge der vorliegenden Beschreibung und der Ansprüche wird unter einem Teilerezirkulationselement stets ein zum Rezirkulieren von Teilen vorgesehenes Element verstanden. Ein solches Teilerezirkulationselement kann z.B. als separater Abschnitt, als bezüglich der Rüttelplattform bewegbare Zone bzw Teiletragfläche, als zur Aufnahme von einigen wenigen Teilen ausgebildeter Rezirkulationsbehälter oder als zur Aufnahme einer grossen Menge von Teilen ausgebildeter Speicherbehälter ausgebildet sein.

Das Teilerezirkulationselement wird einerseits in einer ersten Position dazu verwendet, die Rüttelplattform mit Teilen zu beschicken. Sobald die Rüttelplattform mit einer ausreichenden Anzahl von Teilen beschickt ist, werden das Teilerezirkulationselement und die Rüttelplattform relativ zueinander in eine zweite Position gebracht, in welcher das gleiche Teilerezirkulationselement zum Auffangen von Teilen dient, die während des Rüttelns von der Rüttelplattform herunter fallen. Die Rüttelplattform dient gleichzeitig als Selektionszone der Teilezuführungsvorrichtung, d.h., die Teile werden durch den Roboter auf der Rüttelplattform ergriffen und weg gefördert. (Das Ergreifen und Wegfördern der Teile wird auch als Selektieren der Teile bezeichnet.) Wenn die auf der Rüttelplattform verbleibende Anzahl Teile eine Mindestanzahl unterschreitet, werden das Teilerezirkulationselement und die Rüttelplattform relativ zueinander wiederum in die erste Position gebracht, um die Rüttelplattform erneut mit Teilen vom Teilerezirkulationselement zu beschicken. Dadurch werden die von der Rüttelplattform herab auf oder in das Teilerezirkulationselement hinein gefallenen Teile zur Rüttelplattform zurückgeführt und somit rezykliert. Das Teilerezirkulationselement dient somit abwechselnd als Teilereservoir zum Beschicken der Rüttelplattform mit Teilen und als Auffangelement zum Auffangen der von der Rüttelplattform herab fallenden Teile, um diese anschliessend zu rezyklieren. Indem für das Beschicken der Rüttelplattform mit Teilen und das Auffangen der von der Rüttelplattform herab fallenden Teile das gleiche Element verwendet wird, entfällt die Notwendigkeit nach separaten Teile-Transportvorrichtungen für die Rückführung der von der Rüttelplattform herab gefallenen Teile und deren erneute Zufuhr zur Rüttelplattform. Im Gegensatz zu bisher bekannten Teilezuführungsvorrichtungen kommt die erfindungsgemässe Teilezuführungsvorrichtung deshalb ohne jegliche Teiletransportvorrichtungen für eine horizontale Teileförderung, wie Förderbänder, Linearschienen o.ä., aus. Dies erlaubt eine äusserst einfache und raumsparende Konstruktion der erfindungsgemässen Teilezuführungsvorrichtung. Zudem kann durch die Elimination der für eine Blockierung anfälligen Förderbänder und Linearschienen die Gefahr einer Blockierung der ganzen Teilezuführungsvorrichtung wesentlich vermindert werden.

Die Rüttelplattform und das Teilerezirkulationselement sind relativ zueinander bewegbar. Zur Erzeugung der Relativbewegung können entweder die Rüttelplattform im wesentlichen fest an einem Gestell der Teilezuführungsvorrichtung und das Teilerezirkulationselement beweglich bezüglich dieses Gestells und somit der Rüttelplattform angeordnet sein. Oder es können umgekehrt das Teilerezirkulationselement fest am Gestell der Teilezuführungsvorrichtung und die Rüttelplattform beweglich am Gestell angeordnet sein. Es versteht sich von selbst, dass grundsätzlich auch sowohl das Teilerezirkulationselement als auch die Rüttelplattform beweglich am Gestell der Teilezuführungsvorrichtung angeordnet sein können, um eine Relativbewegung zwischen dem Teilerezirkulationselement und der Rüttelplattform bereit zu stellen.

Das Teilerezirkulationselement kann muldenförmig ausgebildet sein, d.h. als nach oben offener Behälter mit einem Boden und Seitenwänden, um das Auffangen der Teile in der zweiten Position zu unterstützen. Die Teile können dann einfach von oben herab in das muldenförmigen Teilerezirkulationselement hinein fallen.

Vorzugsweise ist das Teilerezirkulationselement mit einer auswechselbaren oberen Partie versehen, wobei die Oberseite dieser oberen Partie für eine gewünschte Anzahl von Teilen angepasst ist, die in der ersten Position des Teilerezirkulationselementes zum Beschicken der Rüttelplattform vom Teilerezirkulationselement auf die Rüttelplattform gefördert werden.

Gemäss einer bevorzugten Ausführungsform der Erfindung ist das Teilerezirkulationselement in unmittelbarer Nähe der Rüttelplattform angeordnet und nach Art eines Liftes in vertikaler Richtung zwischen der ersten Position zum Beschicken der Rüttelplattform und der zweiten Position zum Auffangen der Teile verschiebbar. In der ersten, angehobenen Position ist das Teilerezirkulationselement auf einem bezüglich der Rüttelplattform derart erhöhten Niveau angeordnet, dass die Teile im wesentlichen durch die Schwerkraft vom Teilerezirkulationselement auf die Rüttelplattform gefördert werden. In der zweiten, abgesenkten Position ist das Teilerezirkulationselement auf einem bezüglich der Rüttelplattform tieferen Niveau derart angeordnet ist, dass die durch das Rütteln der Rüttelplattform von dieser herab fallenden Teile im wesentlichen aufgrund der Schwerkraft auf bzw. in das Teilerezirkulationselement hinein fallen. Zum Beschikken der Rüttelplattform mit Teilen kann ein muldenförmig ausgebildetes Teilerezirkulationselement mit einer seitlichen Austrittsöffnung versehen sein. Als Alternative kann ein Teilerezirkulationselement auch trichterförmig ausgebildet sein, wobei die Rüttelplattform in der Mitte des trichterförmigen Teilerezirkulationselementes angeordnet ist. Vorzugsweise ist der die Teile tragende Boden des Teilerezirkulationselementes zur Rüttelplattform hin abfallend geneigt, so dass die Teile allein aufgrund der Schwerkraft zur Rüttelplattform hin strömen. Dies stellt eine äusserst einfache Möglichkeit zur Teileförderung innerhalb des Teilerezirkulationselementes dar.

Bei einer Teilezuführungsvorrichtung für einen Roboter mit einer für den Roboter zugänglichen Selektionszone und einer Einrichtung zum stochastischen Verändern der Ausrichtung und/oder der Lage der Teile kann die Einrichtung zum stochastischen Verändern der Ausrichtung und/oder der Lage der Teile eine gleichzeitig als Selektionszone ausgebildete Rüttelplattform sein, wobei die Rüttelplattform zum Ausführen von Rüttelbewegungen mit einem einzigen mechanischen Freiheitsgrad ausgebildet ist. Dabei wird unter der Anzahl der Freiheitsgrade eines mechanischen Systems wie üblich die Anzahl der voneinander unabhängigen Bestimmungsstücke (Koordinaten) verstanden, die zur eindeutigen Bestimmung des Systems notwendig sind. So besitzt z.B. ein im Raum frei beweglicher Massenpunkt drei mechanische Freiheitsgrade, während ein auf einer Kurve beweglicher Massepunkt einen Freiheitsgrad besitzt. Weil bei einer Teilezuführungsvorrichtung gemäss dieser Erfindungsvariante die gesamte Rüttelplattform bloss mit einem einzigen mechanischen Freiheitsgrad bewegt werden muss, können die Rüttelplattform selbst, der Antrieb zur Erzeugung der Rüttelbewegung uns somit die gesamte Teilezuführungsvorrichtung äusserst einfach und kostengünstig konstruiert werden. So kann z.B. für den Antrieb der Rüttelplattform eine kostengünstige, einfache Vibriereinrichtung verwendet werden, wie sie für Baumaschinen gebräuchlich ist. Es leuchtet ein, dass dieser Aspekt der Erfindung nicht zwingend im Zusammenhang mit dem bezüglich der Rüttelplattform bewegbaren Teilerezirkulationselement zum Rezirkulieren der Teile eingesetzt werden muss.

Vorzugsweise ist die mit einem einzigen mechanischen Freiheitsgrad bewegbare Rüttelplattform zum Ausführen von Rüttelbewegungen im wesentlichen in vertikaler Richtung ausgebildet, so dass die Vibrationen bzw. die Rüttelbewegungen ausschliesslich in vertikaler Richtung erfolgen. Im Gegensatz zu bisherigen Teilezuführungsvorrichtungen werden die Teile dann durch die Rüttelplattform nicht gezielt in eine horizontale Richtung gefördert. Die Rüttelplattform hat einzig die Funktion, durch wiederholtes Aufwerfen der Teile diese zu vereinzeln und ihre Ausrichtung sowie ihre Lage stochastisch zu verändern. Weiter ist es von Vorteil, wenn die Rüttelplattform mit einer Antriebseinrichtung zur Erzeugung der Rüttelbewegung versehen ist, welche ein wahlweises Einstellen der Frequenz, der Amplitude und der Dauer der Rüttelbewegung ermöglicht. Die Frequenz, die Amplitude und die Dauer der Rüttelbewegung können insbesondere softwaremässig einstellbar sein, um eine programmierbare Steuerungsvorrichtung zur Steuerung der Rüttelplattform bereit zu stellen. Durch die Einstellung der Frequenz, der Amplitude und der Dauer der Rüttelbewegung kann die Teilezuführungsvorrichtung auf einfache Art an unterschiedliche Teileformen angepasst werden. Vor der Verarbeitung von Teilen mit einer neuen Form können diese Parameter in einer Einstell- oder Testphase für eine möglichst grosse Effizienz hinsichtlich der gewünschten Ausrichtung und/oder Lage der zu verarbeitenden Teile optimiert werden.

Die Rüttelplattform einer erfindungsgemässen Teilezuführungsvorrichtung kann weiter mit einer auswechselbaren Auflagefläche an der Plattformoberseite versehen sein, wobei die Auflagefläche (englisch "tooling plate"), auf welcher die Teile zu liegen kommen, strukturiert und auf bestimmte Teileformen und/oder bestimmte Teilefamilien angepasst sein kann. Dadurch wird die Möglichkeit geschaffen, die Teile durch stochastisches Rütteln in einer Ausrichtung anzuordnen, deren Auftretenswahrscheinlichkeit vergleichsweise klein ist. Auf diese Art können z.B. Teile auf ihrer Schmalseite stehend angeordnet werden. Die auswechselbare Auflagefläche ermöglicht nebst den oben erwähnten einstellbaren Parametern der Rüttelbewegung eine weitere einfache Anpassungsmöglichkeit der Teilezuführungsvorrichtung für unterschiedliche Teileformen, indem für eine neue Teileform die Auflagefläche ausgewechselt und durch eine auf die neue Teileform angepasste Auflagefläche ersetzt werden kann.

Gemäss einer weiteren bevorzugten Ausführungsform der Erfindung umfasst die Teilezuführungsvorrichtung weiter eine Detektionsvorrichtung zum Detektieren der Ausrichtung und der Lage der Teile auf der Rüttelplattform sowie Datenübertragungsmittel zum Übertragen der detektierten Ausrichtungen und Lagen an den Roboter, um die Selektion der Teile durch den Roboter auf der gleichzeitig als Selektionszone dienenden Rüttelplattform zu unterstützen. Vorzugsweise umfasst die Detektionsvorrichtung Mittel zur optischen Ausrichtungs- und Lageerkennung sowie Mittel zur Beleuchtung der Rüttelplattform, wobei die optischen Detektionsmittel und die Beleuchtungsmittel in einem gemeinsamen Gehäuse angeordnet sind. Das Gehäuse kann mit einer zur Plattform hin gerichteten Sichtöffnung versehen sein, wobei das Gehäuse vorzugsweise bloss in Richtung zur Plattform hin offen ist, um Störungen durch Fremdlichteinflüsse zu verhindern. Weiter kann das Gehäuse über die Rüttelplattform hinweg bewegbar sein, um die Ausrichtung und die Lage der Teile zu detektieren. Dazu kann das Gehäuse auf einer im wesentlichen horizontalen Fahrschiene angeordnet über der Rüttelplattform angeordnet sein. Durch die in einem Gehäuse zusammen mit den Beleuchtungsmitteln über die Rüttelplattform verfahrbare Kamera wird die Teilezuführungsvorrichtung unabhängig vom Roboter, dem sie die Teile zuführt. Bei einer Teilezuführungsvorrichtung mit einer stationären Kamera und einem Roboter, der sich im Sichtbereich zwischen der Kamera und der Selektionszone bewegt, ist dies nicht der Fall.

Gemäss einem erfindungsgemässen Verfahren für den Betrieb einer Teilezuführungsvorrichtung für einen Roboter werden in einem kontinuierlichen Endlosvorgang nacheinander die folgenden Schritte ausgeführt: In einem ersten Schritt werden eine zum stochastischen Verändern der Ausrichtung und/oder der Lage der Teile durch Rütteln ausgebildete Rüttelplattform und ein Teilerezirkulationselement relativ zueinander in eine erste Position bewegt, worauf in dieser ersten Position die Rüttelplattform mit Teilen vom Teilerezirkulationselement beschickt wird. In einem zweiten Schritt werden die Rüttelplattform und das Teilerezirkulationselement relativ zueinander in eine zweite Position bewegt zum Auffangen von Teilen, die von der Rüttelplattform herab fallen. Die Teile werden in bzw. auf diesem Teilerezirkulationselement aufgefangen. In einem dritten Schritt werden die Ausrichtung und/oder der Lage der Teile auf der Rüttelplattform durch Rütteln der Rüttelplattform stochastisch verändert, wobei allfällige von der Rüttelplattform herab fallende Teile vom Teilerezirkulationselement aufgefangen werden. In einem vierten Schritt werden die Ausrichtung und die Lage der Teile auf der Rüttelplattform detektiert und die entsprechenden Ausrichtungs- und Lagedaten an den Roboter übermittelt. In einem fünften Schritt werden in Abhängigkeit der übermittelten Ausrichtungs- und Lagedaten der Teile allfällige Teile mit günstiger Ausrichtung und Lage durch den Roboter auf der gleichzeitig als Selektionszone dienenden Rüttelplattform ergriffen und weg gefördert, d.h. selektiert. In einem sechsten Schritt wird die Anzahl der auf der Rüttelplattform verbliebenen Teile bestimmt, worauf in Abhängigkeit dieser Anzahl entweder zum dritten Schritt oder zum ersten Schritt zurückgekehrt wird. Wenn die Anzahl der auf der Rüttelplattform verbliebenen Teile kleiner ist als eine vorgegebene Mindestanzahl, so wird zum ersten Schritt zurückgekehrt, sonst zum dritten Schritt.

Bei einer Variante des Verfahrens kann anstelle der Steuerung durch den sechsten Schritt die Rückkehr zum ersten Schritt durch den Ablauf einer vorgegebenen Zeit seit der letzten Ausführung des ersten Schrittes gesteuert werden. Bei einer anderen Variante kann diese Rückkehr zum ersten Schritt durch die Flächenbedeckung der Rüttelplattform gesteuert werden.

Im Falle eines muldenförmig ausgebildeten Teilerezirkulationselementes kann das Verfahren weiter einen siebten Schritt umfassen, der vor der Rückkehr zum ersten Schritt nach dem sechsten Schritt ausgeführt wird, wobei in diesem siebten Schritt die Anzahl der Teile im Teilerezirkulationselement bestimmt und in Abhängigkeit dieser Anzahl das Teilerezirkulationselement mit neuen Teilen gefüllt wird. Als Alternative zum Einfüllen der neuen Teile in das muldenförmige Teilerezirkulationselement können die neuen Teile durch eine zusätzliche Fördereinrichtung auch direkt auf die Rüttelplattform gefördert werden.

Vorzugsweise wird das erfindungsgemässe Verfahren für den Betrieb einer Teilezuführungsvorrichtung für einen Roboter vollkommen automatisch ausgeführt, so dass keine Manipulationen von Hand erforderlich sind.

Die nachfolgende detaillierte Beschreibung der vorliegenden Erfindung dient in Verbindung mit den beiliegenden Zeichnungen nur als Beispiel für ein besseres Verständnis der Erfindung und ist nicht als Einschränkung des Schutzbereichs der Patentansprüche aufzufassen. Für den Fachmann sind aus der nachfolgenden Beschreibung in Verbindung mit den beiliegenden Zeichnungen und der Gesamtheit der Patentansprüche weitere vorteilhafte Ausführungsarten und Merkmalskombinationen ohne weiteres erkennbar, die jedoch immer noch innerhalb des Bereichs der vorliegenden Erfindung liegen.

### Kurze Beschreibung der Zeichnungen

Die zur Erläuterung der Ausführungsbeispiele verwendeten Zeichnungen zeigen:
- Fig. 1: eine bevorzugte Ausführungsart einer erfindungsgemässen Teilezuführungsvorrichtung für einen Roboter in einer vereinfachten Draufsicht von oben;
- Fig. 2: die Teilezuführungsvorrichtung aus Fig. 1 in einer entlang der Linie A-A geschnittenen vereinfachten Seitenansicht;
- Fig. 3: eine diagrammartige, schematische Darstellung des Ablaufs einer bevorzugten Ausführungsart des erfindungsgemässen Verfahrens für den Betrieb einer Teilezuführungsvorrichtung für einen Roboter.

### Wege zur Ausführung der Erfindung

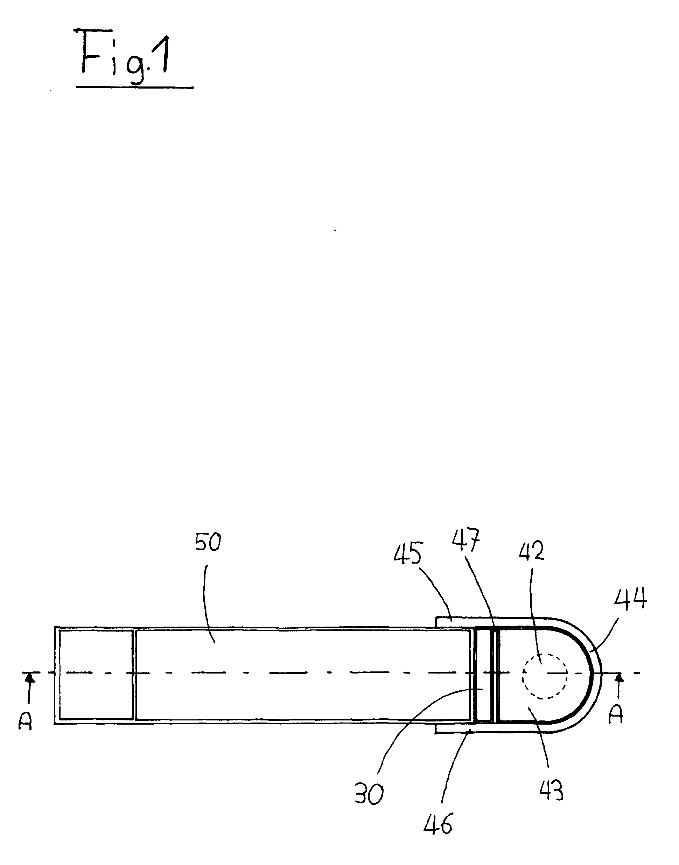

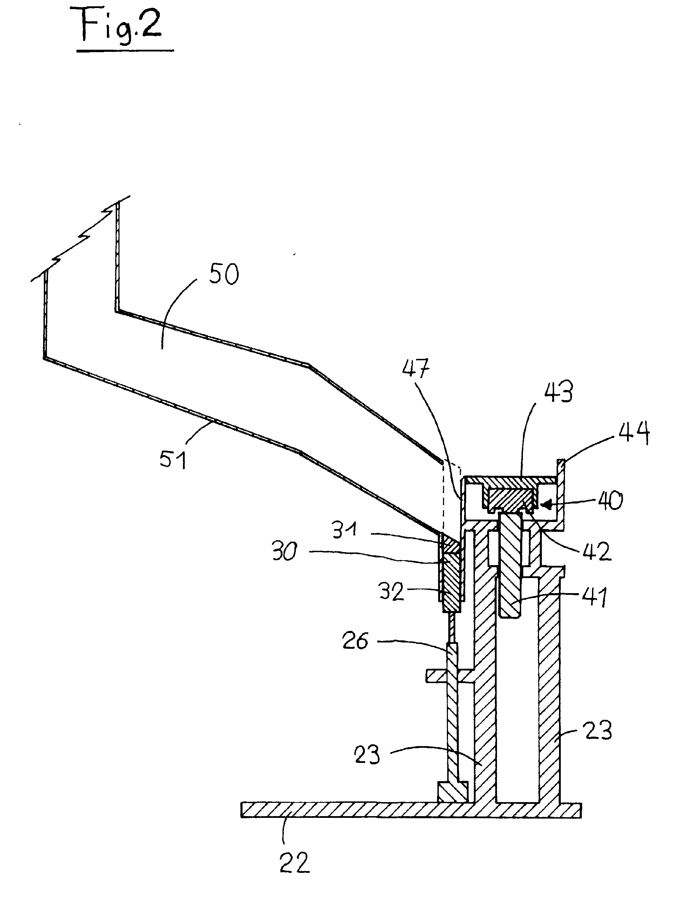

Die in Fig. 1 und 2 dargestellte Teilezuführungsvorrichtung für einen Roboter (nicht dargestellt) umfasst ein Gestell mit einem Sockel 22, an welchem eine solide, vertikal nach oben ragende, hohlzylindrische Säule 23 befestigt ist. Im oberen Bereich der Säule 23 ist ein den Antrieb einer Vibriereinrichtung umfassendes Gehäuse 41 fest angebracht. Das Gehäuse 41 ist im wesentlichen im hohlen Innenraum der hohlzylindrischen Säule 23 angeordnet. Die Vibreireinrichtung in Form eines pneumatischen Vibrators, wie er für Anwendungen in Baumaschinen weit verbreitet verwendet wird, umfasst weiter ein Basisteil 42, däs bezüglich des Vibratorgehäuses 41 beweglich ist, wobei es durch den Vibratorantrieb zu im wesentlichen vertikal gerichteten Vibrier- oder Rüttelbewegungen angeregt wird. (Das in der Draufsicht der Fig. 1 eigentlich verdeckte Basisteil ist in Fig. 1 mit unterbrochenen Linien angedeutet.) Der Vibrator 41, 42 ist mit einer Vibrator-Steuerungsvorrichtung versehen, welche eine computergesteuerte Einstellung der Frequenz, der Amplitude und der Dauer des Vibrierens ermöglicht.

Auf dem Basisteil 42 des Vibrators ist eine plattenähnliche Auflagefläche 43 (englisch "tooling plate") angeordnet, welche als Auflage für die durch die Teilezuführungsvorrichtung dem Roboter zuzuführenden Teile dient. Die Auflagefläche 43 ist fest mit dem Basisteil 42 verbunden und bildet mit diesem zusammen eine bezüglich des Vibratorgehäuses 41 bzw. der Säule 23 in Rüttelbewegungen bewegliche Rüttelplattform 40, um in einem Rüttelvorgang die Ausrichtung und/oder die Lage der auf der Rüttelplattform 40 bzw. der Auflagefläche 43 liegenden Teile stochastisch zu verändern. Die Auflagefläche 43 kann bei Bedarf vom Basisteil 42 gelöst und durch eine andere Auflagefläche ersetzt werden, um die Rüttelplattform 40 an unterschiedliche Teileformen anzupassen. Insgesamt ist die Rüttelplattform 40 derart auf der Säule 23 gelagert, dass sie im wesentlichen bloss in vertikaler Richtung bezüglich der Säule 23 bewegbar ist, um Rüttel- oder Vibrationsbewegungen in vertikaler Richtung ausführen zu können. In horizontaler Richtung hingegen ist die Rüttelplattform 40 unverschieblich bezüglich der Säule 23 angeordnet.

Seitlich der Rüttelplattform 40 ist unmittelbar an diese anschliessend ein Teilerezirkulationselement 30 bzw. ein Teileförderelement 30 angeordnet, das zum Fördern der durch die Teilezuführungsvorrichtung dem Roboter zuzuführenden Teile dient. Das Teilerezirkulationselement 30 ist nach Art eines Liftes in im wesentlichen vertikaler Richtung zwischen einer ersten Position zum Beschicken der Rüttelplattform 40 mit Teilen vom Teilerezirkulationselement 30 und einer zweiten Position zum Auffangen von Teilen, die von der Rüttelplattform 40 herunter fallen, bezüglich der Säule 23 und bezüglich der Rüttelplattform 40 verschiebbar.

Zum Zwecke des Verschiebens in vertikaler Richtung wird das Teilerezirkulationselement 30 durch eine an der Säule 23 angebrachte Linearführung in vertikaler Richtung geführt und durch einen zwischen der Säule 23 und dem Teilerezirkulationselement 30 wirkenden Hubantrieb 26 in Form' einer pneumatischen Kolben-Zylinder-Anordnung in vertikaler Richtung angetrieben.

Auf der von der Rüttelplattform 40 entfernten Seite des Teilerezirkulationselementes 30 ist seitlich an dieses anschliessend ein Teilespeicherbehälter 50 bzw. ein Teilereservoir 50 angeordnet, welcher bzw. welches zur Aufnahme einer grossen Menge von dem Roboter zuzuführenden Teilen ausgebildet ist. Der Boden 51 des Teilespeicherbehälters 50 ist zur Seite des Teilerezirkulationselementes 30 hin derart abfallend geneigt, dass die Teile allein aufgrund der Schwerkraft zu dieser Seite des Teilespeicherbehälters 50 hin rutschen. Der Teilespeicherbehälter 50 hat somit gleichzeitig die Funktion einer Zufuhrrutsche, welche die Teile zum Teilerezirkulationselement 30 hin fördert.

Das Teilerezirkulationselement 30 bildet in Bezug auf die Förder- bzw. Strömungsrichtung der Teile im Teilespeicherbehälter 50 eine vordere Begrenzungswand des Teilespeicherbehälters 50, welche nach Art eines Schiebers in vertikaler Richtung verschiebbar ist, um den Teilespeicherbehälter 50 wahlweise zu öffnen oder zu schliessen. Wenn sich das Teilerezirkulationselement 30 in der ersten Position (in Fig. 2 mit unterbrochenen Linien dargestellt) zum Beschicken der Rüttelplattform 40 mit Teilen vom Teilerezirkulationselement 30 befindet, so wird der Teilespeicherbehälter 50 durch die zum Teilespeicherbehälter 50 hin gerichtete Seite des Teilerezirkulationselementes 30 begrenzt und geschlossen. In der in Fig. 2 mit durchgezogenen Linien dargestellten zweiten, abgesenkten Position des Teilerezirkulationselementes 30 ist der Teilespeicherbehälter 50 nach vorne, in Richtung zum Teilerezirkulationselement 30 und zur Rüttelplattform 40 hin, offen. In dieser zweiten Position dient das Teilerezirkulationselementes 30 einerseits zum Auffangen von Teilen, die von der Rüttelplattform 40 herunter fallen. Andrerseits können in dieser zweiten Position gleichzeitig Teile vom Teilespeicherbehälter 50 auf das Teilerezirkulationselement 30 strömen. Beim nächsten Anheben des Telerezirkulationselementes 30 in die erste Position können dann sämtliche der auf dem Teilerezirkulationselement 30 liegenden Teile, d.h. sowohl die von der Rüttelplattform 40 herunter gefallenen Teile als auch die vom Speicherbehälter 50 auf das Teilerezirkulationselement 30 geströmten Teile, auf die Rüttelplattform 40 gefördert werden.

Das Teilerezirkulationselement 30 weist eine im wesentlichen rechteckige Oberseite auf, auf welche die aus dem Teilespeicherbehälter 50 rutschenden Teile und/oder die von der Rüttelplattform 40 herab fallenden Teile zu liegen kommen. Diese Oberseite des Teilerezirkulationselementes 30 hat die Funktion einer Teiletragfläche zum Tragen der Teile. Beim Verschieben des Teilerezirkulationselementes 30 nach oben hat diese Teiletragfläche in Bezug auf die auf ihr liegenden Teile die Funktion einer Förderplattform oder einer Hebebühne, auf welcher die Teile nach oben gefördert werden.

Das Teilerezirkulationselement 30 ist aus zwei Partien zusammengesetzt, nämlich einer unteren Partie 32, die mit der oben erwähnten Hubvorrichtung 26 verbunden ist, und einer oberen Partie 31, welche die oben erwähnte Teiletragfläche oder Oberseite des Teilerezirkulationselementes 30 aufweist. Die obere Partie 32 kann bei Bedarf von der unteren Partie 31 gelöst und durch eine andere obere Partie ersetzt werden. Diese andere obere Partie kann eine anders gestaltete Oberseite aufweisen. Durch eine entsprechende Ausgestaltung der Oberseite des der oberen Partei (und somit der Oberseite des Teilerezirkulationselementes 30) kann die Menge an Teilen besitmmt werden, die bei jedem Hubvorgang mittels des Teilerezrikulationselementes 30 auf die Rüttelplattform 40 gefordert werden. So kann diese Oberseite beispielsweise keilförmig ausgebildet werden, mit einer zur Rüttelplattform 40 hin abfallenden Fläche und einer zum Teilespeicherbehälter 50 hin abfallenden Fläche. Bei jedem Hubvorgang werden dann nur noch die auf der zur Rüttelplattform 40 hin abfallenden Fläche liegenden Teile auf die Rüttelplattform 40 gefördert.

Die als Teiletragfläche dienende, im wesentlichen ebene Oberseite des Teilerezirkulationselementes 30 ist zur Seite der Rüttelplattform 40 hin abfallend geneigt. In der zweiten, abgesenkten Position des Teilerezirkulationselementes 30 bildet die geneigte Oberseite des Teilerezirkulationselementes 30 eine vordere Verlängerung des Bodens 51 des Teilespeicherbehälters 50, wobei die Teile aufgrund der Schwerkraft vom Teilespeciherbehälter 50 auf die Oberseite des Teilerezirkulationselementes 30 rutschen. Die Neigung der Oberseite des Teilerezirkulationselementes 30 ist derart gewählt, dass, wenn sich das Teilerezirkulationselement 30 in der ersten (erhöhten) Position zum Beschicken der Rüttelplattform 40 mit Teilen vom Teilerezirkulationselement 30 befindet, die Teile auf der Oberseite des Teilerezirkulationselementes 30 allein aufgrund der Schwerkraft zur Rüttelplattform 40 hin strömen bzw. rutschen.

Entlang seines vertikalen Verschiebungsweges ist das einen im wesentlichen rechtekkigen Querschnitt aufweisende Teilerezirkulationselement 30 auf drei Seiten von vertikalen Begrenzungswänden 45, 46, 47 umschlossen, die fest an der Säule 23 angebracht sind. In der zweiten, abgesenkten Position des Teilerezirkulationselementes 30 bilden diese Begrenzungswände 45, 46, 47 einen auf drei Seiten geschlossenen vertikalen Schacht, in welchen hinein die von der Rüttelplattform 40 herab fallenden Teile fallen. Der Schachtquerschnitt entspricht dem Querschnitt des Teilerezirkulationselementes 30. Der Boden des Schachtes wird durch die Oberseite des Teilerezirkulationselementes 30 gebildet. Auf der vierten Seite des Teilerezirkulationselementes 30, zum Teilespeicherbehälter 50 hin, ist der Schacht offen.

Die zwischen der Rüttelplattform und dem Teilerezirkulationselement 30 angeordnete Schachtwand 47 erstreckt sich vom Niveau der Rüttelplattform 40 bzw. ihrer Auflagefläche 43 an nach unten. In der ersten, erhöhten Position des Teilerezirkulationselementes 30 überragt die gesamte Oberseite des Teilerezirkulationselementes 30 den oberen Rand dieser Wand 47. Die Oberseite des Teilerezirkulationselementes 30 liegt in dieser ersten Position auf einem höheren Niveau als die Rüttelplattform 40, so dass die Teile über den oberen Rand der dazwischenliegenden Schachtwand 47 hinweg vom des Teilerezirkulationselement 30 auf die Rüttelplattform 40 rutschen. In der zweiten, abgesenkten Position des Teilerezirkulationselementes 30 liegt die Oberseite des Teilerezirkulationselementes 30 auf einem tieferen Niveau als das Niveau der Rüttelplattform 40, und die Teile fallen über den oberen Rand der dazwischenliegenden Schachtwand 47 hinweg von der Rüttelplattform 40 auf das Teilerezirkulationselement 30.

Die beiden anderen Schachtwände 45, 46 sind als Verlängerung einer eng an der Rüttelplattform 40 anliegenden und diese U-förmig umschliessenden vertikalen Begrenzungswand 44 ausgebildet. Auch diese Begrenzungswand 44 ist fest an der Säule 23 der Teilezuführungsvorrichtung angebracht. Sie erstreckt sich nach oben über das Niveau der Rüttelplattform 40 hinaus und verhindert, dass die Teile auf den durch die Begrenzungswand 44 abgeschlossenen Seiten von der Rüttelplattform 40 herab fallen können. Die Teile können bloss auf der Seite zum Teilerezirkulationselement 30 hin von der Rüttelplattform 40 herab fallen. Die beiden schenkelartigen Verlängerungen 45, 46 dieser Begrenzungswand 44 mit U-förmigem Grundriss umschliessen das Teilerezirkulationselement 30 auf zwei Seiten und bilden je eine Seitenwand 45, 46 des oben erwähnten Schachtes. Sie erstrecken sich nach oben über Oberseite des Teilerezirkulationselementes 30 in seiner ersten, angehobenen Position hinaus, um zu verhindern, dass die Teile auf eine andere Seite als zur Rüttelplattform 40 hin vom Teilerezirkulationselementes 30 herunter fallen können.

Die in Fig. 1 und 2 dargestellte Teilezuführungsvorrichtung ist weiter mit einer Detektionsvorrichtung (nicht dargestellt) zum Detektieren der Ausrichtung und der Lage der Teile auf der Rüttelplattform 40 sowie mit Datenübertragungsmitteln versehen, um die detektierten Ausrichtungen und Lagen an den Roboter zu übertragen, damit dieser die Teile auf der Rüttelplattform 40 aufgrund der von der Detektionsvorrichtung empfangenen Ausrichtungs- und Lagedaten selektieren (d.h. ergreifen und weg fördern) kann. Die Detektionsvorrichtung umfasst eine Kamera zur optischen Ausrichtungs- und Lageerkennung sowie Mittel zur Beleuchtung der Rüttelplattform 40, wobei die Kamera und die Beleuchtungsmittel in einem gemeinsamen Gehäuse angeordnet sind. Das Gehäuse ist mit einer zur Rüttelplattform 40 hin weisenden Sicht- und Beleuchtungsöffnung versehen. Ansonsten ist das Gehäuse lichtundurchlässig abgeschlossen, um Störungen durch Fremdlichteinflüsse zu verhindern. Das Kamera- und Beleuchtungsgehäuse ist auf zwei im wesentlichen horizontalen Führungsschienen über die Rüttelplattform 40 hinweg verfahrbar, um die Ausrichtung und die Lage der Teile zu detektieren.

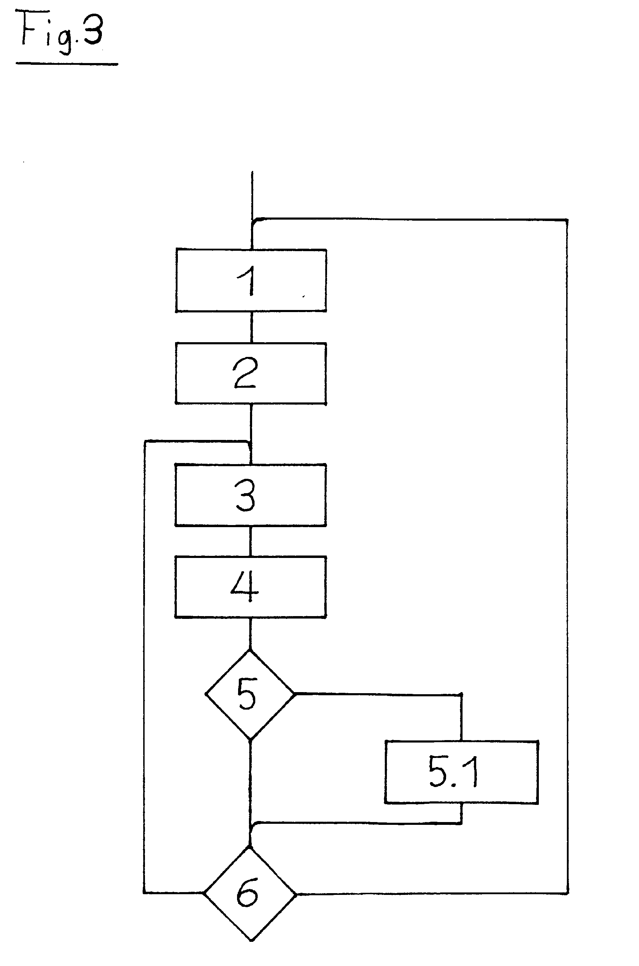

Für den Betrieb der in Fig. 1 und 2 dargestellten Teilezuführungsvorrichtung für einen Roboter werden in einem kontinuierlichen Endlosvorgang nacheinander die folgenden Schritte ausgeführt, die in Fig. 3 diagrammartig dargestellt sind.

In einem ersten Schritt 1 wird das Teilerezirkulationselement 30 in seine erste Position zum Beschicken der Rüttelplattform 40 mit Teilen vom Teilerezirkulationselement 30 gebracht und die Rüttelplattform 40 mit Teilen vom Teilerezirkulationselement 30 beschickt. Dabei strömen die Teile allein aufgrund der Schwerkraft vom Teilerezirkulationselement 30 direkt auf die Rüttelplattform 40.

In einem zweiten Schritt 2 wird das Teilerezirkulationselement 30 in seine zweite Position zum Auffangen von Teilen, die von der Rüttelplattform 40 herunter fallen, gebracht.

In einem dritten Schritt 3 wird die Rüttelplattform 40 in einem Rüttel- oder Vibrationsvorgang gemäss der eingestellten Frequenz, Amplitude und der Dauer gerüttelt. Durch die Rüttelbewegung der Plattform 40 werden die auf der Rüttelplattform 40 liegenden Teile wiederholt aufgeworfen, um sie zu vereinzeln und ihre Ausrichtung sowie ihre Lage stochastisch zu verändern. Während des Rüttelvorgangs können einzelne Teile von der Rüttelplattform 40 über deren dem Teilerezirkulationselement 30 zugewandten Rand von der Plattform 40 herunter fallen, wobei sie direkt auf das Teilerezirkulationselement 30 fallen.

In einem vierten Schritt 4 werden sodann bei ruhender Rüttelplattform 40 die Ausrichtung und die Lage der Teile auf der Rüttelplattform 40 detektiert, indem das Gehäuse mit der Kamera und den Beleuchtungsmitteln über die Rüttelplattform 40 hinweg verfahren wird. Dabei wird die Rüttelplattform 40 durch die Beleuchtungsmittel beleuchtet und die Oberfläche der Rüttelplattform 40 durch die Kamera optisch abgetastet. Mittels einer geeigneten Bilderkennungsvorrichtung werden aufgrund der durch die Kamera ermittelten optischen Daten die Ausrichtung und die Lage der Teile auf der Rüttelplattform 40 ermittelt und die für eine Selektion durch den Roboter geeignet ausgerichteten und positionierten Teile bestimmt und deren Ausrichtungs- und Lagedaten an den Roboter übermittelt.

In einem fünften Schritt 5 wird zunächst anhand der ermittelten Ausrichtungs- und Lagedaten überprüft, ob es für eine Selektion durch den Roboter geeignete Teile auf der Rüttelplattform 40 gibt. Falls dies zutrifft, werden in einem Teilschritt 5.1 in Abhängigkeit der übermittelten Ausrichtungs- und Lagedaten die Teile mit günstiger Ausrichtung und Lage durch den Roboter selektiert, d.h., sie werden direkt auf der ruhenden Rüttelplattform 40 durch den Roboter ergriffen und zur Weiterverarbeitung weg gefördert. Falls es keine geeigneten Teile auf der Rüttelplattform 40 gibt, wird der Teilschritt 5.1 ausgelassen.

In einem sechsten Schritt 6 wird zunächst die Anzahl der auf der Rüttelplattform 40 verbliebenen Teile bestimmt. Darauf wird in Abhängigkeit dieser Anzahl entweder zum dritten Schritt oder zum ersten Schritt zurückgekehrt. Wenn die Anzahl der auf der Rüttelplattform 40 verbliebenen Teile kleiner ist als eine vorgegebene Mindestanzahl, so wird zum ersten Schritt zurückgekehrt, sonst zum dritten Schritt.

Es ist nicht zwingend erforderlich, dass sämtliche Schritte des Verfahrens vollständig nacheinander ausgeführt werden, vielmehr können einzelne Schritte auch mindestens teilweise überlappend ausgeführt werden, um den Ablauf des Verfahrens zu beschleunigen.

Zusammenfassend ist festzustellen, dass durch die Erfindung eine Teilezuführungsvorrichtung geschaffen wird, die konstruktiv einfach, raumsparend und flexibel in Bezug auf unterschiedliche Teileformen ist.

## Patentansprüche

1. Teilezuführungsvorrichtung für einen Roboter, mit einer für den Roboter zugänglichen Selektionszone (40), einer Einrichtung (40) zum stochastischen Verändern der Ausrichtung und/oder der Lage der Teile und einer Einrichtung mit einem Teilerezirkulationselement (30) zum Rezirkulieren der Teile, dadurch gekennzeichnet, dass die Einrichtung (40) zum stochastischen Verändern der Ausrichtung und/oder der Lage der Teile eine gleichzeitig als Selektionszone (40) ausgebildete Rüttelplattform (40) ist, wobei das Teilerezirkulationselement (30) und die Rüttelplattform (40) relativ zueinander derart in zwei verschiedene Positionen bringbar sind, dass in der ersten Position die Rüttelplattform (40) mit Teilen vom Teilerezirkulationselement (30) beschickt werden kann und in der zweiten Position die Teile, die von der Rüttelplattform (40) herunter fallen, vom Teilerezirkulationselement (30) aufgefangen werden können.

2. Teilezuführungsvorrichtung nach Anspruch 1, dadurch gekennzeichnet, dass das Teilerezirkulationselement muldenförmig ausgebildet ist, um das Auffangen der Teile in der zweiten Position zu unterstützen.

3. Teilezuführungsvorrichtung nach Anspruch 1, dadurch gekennzeichnet, dass das Teilerezirkulationselement (30) mit einer auswechselbaren oberen Partie (31) versehen ist, wobei die Oberseite dieser oberen Partie (31) für eine gewünschte Anzahl von Teilen angepasst ist, die in der ersten Position des Teilerezirkulationselementes (30) zum Beschicken der Rüttelplattform (40) vom Teilerezirkulationselement (30) auf die Rüttelplattform (40) gefördert werden.

4. Teilezuführungsvorrichtung nach einem der Ansprüche 1 bis 3, dadurch gekennzeichnet, dass das Teilerezirkulationselement (30) in unmittelbarer Nähe der Rüttelplattform (40) angeordnet und in vertikaler Richtung zwischen der ersten Position zum Beschicken der Rüttelplattform (40) und der zweiten Position zum Auffangen der Teile verschiebbar ist, wobei in der ersten Position das Teilerezirkulationselement (30) auf einem bezüglich der Rüttelplattform (40) derart erhöhten Niveau angeordnet ist, dass die Teile im wesentlichen durch die Schwerkraft vom Teilerezirkulationselement (30) auf die Rüttelplattform (40) gefördert werden, und wobei in der zweiten Position das Teilerezirkulationselement (30) auf einem bezüglich der Rüttelplattform (40) tieferen Niveau derart angeordnet ist, dass die von dieser herab fallenden Teile im wesentlichen aufgrund der Schwerkraft in bzw. auf das Teilerezirkulationselement (30) fallen.

5. Teilezuführungsvorrichtung für einen Roboter, insbesondere nach einem der Ansprüche 1 bis 4, mit einer für den Roboter zugänglichen Selektionszone (40) und einer Einrichtung (40) zum stochastischen Verändern der Ausrichtung und/oder der Lage der Teile, dadurch gekennzeichnet, dass die Einrichtung (40) zum stochastischen Verändern der Ausrichtung und/oder der Lage der Teile eine gleichzeitig als Selektionszone (40) ausgebildete Rüttelplattform (40) ist, wobei die Rüttelplattform (40) zum Ausführen von Rüttelbewegungen mit einem einzigen mechanischen Freiheitsgrad ausgebildet ist.

6. Teilezuführungsvorrichtung nach Anspruch 5, dadurch gekennzeichnet, dass die Rüttelplattform (40) zum Ausführen von Rüttelbewegungen im wesentlichen in vertikaler Richtung ausgebildet ist.

7. Teilezuführungsvorrichtung nach Anspruch 5 oder 6, dadurch gekennzeichnet, dass die Rüttelplattform (40) mit einer Vibriereinrichtung (41, 42) zur Erzeugung der Rüttelbewegung versehen ist, welche ein wahlweises Einstellen der Frequenz, der Amplitude und der Dauer der Rüttelbewegung ermöglicht.

8. Teilezuführungsvorrichtung nach einem der Ansprüche 1 bis 7, dadurch gekennzeichnet, dass die Rüttelplattform (40) mit einer auswechselbaren Auflagefläche (43) an der Plattformoberseite versehen ist, wobei die Auflagefläche (43) eine an die Teileform angepasste Oberflächenstruktur aufweisen kann.

9. Teilezuführungsvorrichtung nach einem der Ansprüche 1 bis 8, dadurch gekennzeichnet, dass sie weiter eine Detektionsvorrichtung zum optischen Detektieren der Ausrichtung und der Lage der Teile auf der Rüttelplattform (40) umfasst sowie Datenübertragungsmittel zum Übertragen der detektierten Ausrichtungs- und Lagedaten an den Roboter.

10. Teilezuführungsvorrichtung nach Anspruch 9 dadurch gekennzeichnet, dass sie weiter Mittel zur Beleuchtung der Rüttelplattform (40) umfasst, wobei die Detektionsvorrichtung und die Beleuchtungsmittel in einem gemeinsamen Gehäuse angeordnet sind.

11. Teilezuführungsvorrichtung nach Anspruch 10, dadurch gekennzeichnet, dass das Gehäuse über die Rüttelplattform (40) hinweg bewegbar ist, um die Ausrichtung und die Lage der Teile zu detektieren.

12. Verfahren für den Betrieb einer Teilezuführungsvorrichtung für einen Roboter insbesondere nach einem der Ansprüche 1 bis 10, wobei in einem kontinuierlichen Endlosvorgang die folgenden Schritte ausgeführt werden:
in einem ersten Schritt (1) werden eine zum stochastischen Verändern der Ausrichtung und/oder der Lage der Teile durch Rütteln ausgebildete Rüttelplattform (40) und ein Teilerezirkulationselement (30) relativ zueinander in eine erste Position bewegt, worauf in dieser ersten Position die Rüttelplattform (40) mit Teilen vom Teilerezirkulationselement (30) beschickt wird;
in einem zweiten Schritt (2) werden die Rüttelplattform (40) und das Teilerezirkulationselement (30) relativ zueinander in eine zweite Position bewegt zum Auffangen von Teilen, die von der Rüttelplattform (40) herab fallen, durch das Teilerezirkulationselement (30);
in einem dritten Schritt (3) werden die Ausrichtung und/oder der Lage der Teile auf der Rüttelplattform (40) durch Rütteln der Rüttelplattform (40) stochastisch verändert, wobei allfällige von der Rüttelplattform (40) herab fallende Teile durch das Teilerezirkulationselement (30) aufgefangen werden;
in einem vierten Schritt (4) werden die Ausrichtung und die Lage der Teile auf der Rüttelplattform (40) detektiert und die entsprechenden Ausrichtungs- und Lagedaten an den Roboter übermittelt;
in einem fünften Schritt (5, 5.1) werden in Abhängigkeit der übermittelten Ausrichtungs- und Lagedaten allfällige Teile mit günstiger Ausrichtung und Lage durch den Roboter auf der Rüttelplattform (40) ergriffen und weg gefördert;
in einem sechsten Schritt (6) wird die Anzahl der auf der Rüttelplattform (40) verbliebenen Teile bestimmt, worauf in Abhängigkeit dieser Anzahl entweder zum dritten Schritt (3) oder zum ersten Schritt (1) zurückgekehrt wird.
